# EUROPEAN PATENT APPLICATION

(11) **EP 4 542 632 A1**
(43) Date of publication of application: **23.04.2025**
(21) Application number: 23823558.4
(22) Date of filing: 08.05.2023
(51) Int. Cl.: H01L 21/66, B23K 26/00, B23K 26/57, H01L 21/02, H01L 21/304

(54) **METHOD FOR PRODUCING BONDED LIGHT-EMITTING ELEMENT WAFER AND METHOD FOR TRANSFERRING MICRO-LED**

(30) Priority: 15.06.2022 JP 2022096574
(71) Applicant: Shin-Etsu Handotai Co., Ltd., Tokyo 100-0004 (JP)
(72) Inventor: ISHIZAKI, Junya, Annaka-shi, Gunma 379-0196 (JP)
(74) Representative: Sonnenhauser, Thomas Martin
(86) International application number: PCT/JP2023/017250
(87) International publication number: WO 2023/243255

(57) **Abstract**

The present invention is a method for producing a bonded light-emitting device wafer, in which a light-emitting device structure, to be a micro LED, and a to-be-bonded substrate are bonded with each other via an adhesive, the method includes the steps of bonding the light-emitting device structure to the to-be-bonded substrate via the adhesive to obtain a bonded wafer, producing a map data for removal by optically investigating a failure portion of the bonded wafer, and irradiating the failure portion of the bonded wafer with the laser light for removal from the to-be-bonded substrate based on the map data for removal, causing a portion of the adhesive which is included in the failure portion to absorb the laser light for removal and causing the portion of the adhesive which is included in the failure portion to sublimate, thereby removing the portion of the light-emitting device structure which is included in the failure portion to obtain the bonded light-emitting device wafer. This can provide the method for producing a bonded light-emitting device wafer capable of selectively removing the failure portion of the light-emitting device structure and producing the bonded light-emitting device wafer.

## Description

### TECHNICAL FIELD

The present invention relates to a method for producing a bonded light-emitting device wafer and a method for transferring a micro LED.

### BACKGROUND ART

As for a wafer for an AlGaInP-based micro LED (µ-LED), a technique of a bonded wafer in which the bonding is performed by using BCB is disclosed.

In the wafer described above, a bonding-failure portion may be generated due to surface conditions on the bonded wafer and a to-be-bonded wafer, or the presence of foreign matters on an epitaxial layer or a bonding interface because wafers are bonded to each other.

In many cases, the bonding-failure portion is protrusion-shaped, which causes degrading precision of a shape and a dimension during the step of producing a device structure and, particularly, during processing by photolithography.

In addition, when transferring µ-LED dice produced from a wafer having such a protrusion-shaped failure portion to a transfer destination substrate, the protrusion portions generate non-uniformity in applied pressure, which results in a transfer failure.

Consequently, when transferring devices from the wafers having bonded µ-LEDs formed thereon, it has been required to remove the failure portion in protrusion-shape before transferring the devices.

With LED dice assuming conventional discrete devices, various methods have been available to physically remove the failure portion.

For example, Patent Document 1 discloses a technique to suck and hold the dice. However, when a single plate is used to suck and hold the dice, it is assumed that all die heights are within a range of a certain tolerance. When the bonding-failure generates protrusion portions on a wafer before device production, heights of the dice after device processing are uneven. Therefore, in the prior technique disclosed here, the failures are generated during transfer. Moreover, this technique is not capable of selectively removing the failure portions because a batch transfer is applied.

Patent Document 2 discloses a technique for picking up dice by an electrostatic method, but as in Patent Document 1, the technique is based on an assumption that the dice are picked up to a single plate jig, and thus this method is not applicable when protrusion-shape portions are generated.

Patent Document 3 discloses a technique for optically detecting failures and mechanically taking out failure dice. In order to mechanically take out the failure dice, it is required that the dice have a certain size (150 µm square) or more), and this technique cannot be applied to µ-LED dice having a size of less than 100 µm square.

Even if it is possible to pick up the failure dice by improving the technique in Patent Document 3, the failure portions are firmly bonded to a to-be-bonded wafer by BCB; therefore, it is impossible to mechanically pick up the failure portions while retaining the BCB portion.

Thus, the technique for selectively removing the failure portions from epitaxial layer portions for µ-LED or device-processed µ-LEDs, which is firmly bonded to the to-be-bonded wafer via the BCB, is not disclosed in Patent Documents 1 to 3.

Patent Documents 4 and 5 disclose a technique for detecting defects mainly caused by foreign matters in an organic EL and removing the defects by laser irradiation.

Patent Document 6 discloses a faulty LED-removing apparatus to detect failures of LED chips and remove the chips having failures. In Patent Document 6, LEDs having luminance failure are removed with a suction nozzle.

Patent Document 7 discloses a method to optically and electrically evaluate LEDs with respect to malfunctioning defects and remove the LEDs having defects to retain LEDs having excellent quality. In the step of removing defective LEDs in Patent Document 7, a step is performed, in which a laser is used to vaporize LED structures having defects by raising a temperature of the LEDs to higher than a temperature of vaporization, or a step is performed, in which a laser beam is applied along cuts between the defective LEDs to cut a metal substrate.

### CITATION LIST

### PATENT LITERATURE

Patent Document 1: JP 2021-019162 A
Patent Document 2: JP 2018-163900 A
Patent Document 3: JP 2009-21572 A
Patent Document 4: JP 2004-119243 A
Patent Document 5: WO 2010/092749 A1
Patent Document 6: JP 2020-129658 A
Patent Document 7: JP 2008-527719 A

### SUMMARY OF INVENTION

### TECHNICAL PROBLEM

In many cases, a bonding-failure portion appears as an epitaxial layer in a protrusion shape on a side which a starting substrate have being removed side when the starting substrate is removed. In particular, a size of the failure portion having the protrusion shape generated due to BCB curing failure can be as large as about 100 to 300 µm in height and about 500 to 5000 µm in diameter in width, which adversely affects photolithography. When the photolithography is performed by contact exposure, a wafer and a photomask are tightly adhered to each other in a vacuum; thus, the mask is deformed according to TTV (Total Thickness Variation: the difference between a maximum value and a minimum value of thicknesses) of the wafer. When an adhesive failure portion having the protrusion shape is present, incident light from an exposure source is obliquely incident, and a pattern formed is deviated from a mask pattern, resulting in distorted, or enlarged. This causes shapes of a device, an electrode, and a protective film to deviate from designed values, and thus, a size deviation and a position deviation are generated. When such a device is transferred to a mounting substrate, the deviation is generated with a pattern on the mounting substrate side, resulting in a lowered mounting accuracy and an increased failure rate. The deviation from the designed value is difficult to detect by photoluminescence (PL) characteristics inspection or visual inspection; an abnormality is sometimes noticed only after the device is mounted and energized. When the failure is recognized after mounting, re-mounting work is required, resulting in an increase in mounting cost.

In addition, when µ-LED dice produced from such a wafer are transferred to a transfer destination substrate, the protrusion portion generates non-uniformity in applied pressure and tends to generate a transfer failure.

Moreover, an adhesive layer functions as an adhesive also in the failure portion, and the failure portion is not peeled off or exfoliated by a tensile strength of vacuum sucking or adhesion, and thus, the failure portion is maintained.

Furthermore, the failure portion is not limited to the bonding-failure portion but also includes a device characteristics failure portion. As in the bonding-failure portion, such a device characteristics failure portion is difficult to detect by PL characteristic inspection or visual inspection; an abnormality is sometimes noticed only after the device is mounted and energized.

The present invention has been made to solve the above-described problem. An object of the present invention is to provide a method for producing a bonded light-emitting device wafer capable of producing the bonded light-emitting device wafer, being bonded to a to-be-bonded wafer via adhesive to form a micro LED, by selectively removing a failure portion of a light-emitting device structure and a method for transferring a micro LED that can prevent transferring a faulty micro LED.

### SOLUTION TO PROBLEM

To achieve the above problem, the present invention provides a method for producing a bonded light-emitting device wafer, in which a light-emitting device structure, to be a micro LED, and a to-be-bonded substrate transparent to a laser light for removal are bonded with each other via an adhesive that absorbs the laser light for removal, the method comprising the steps of:
bonding the light-emitting device structure to the to-be-bonded substrate via the adhesive to obtain a bonded wafer;
producing a map data for removal by optically investigating a failure portion of the bonded wafer; and
irradiating the failure portion of the bonded wafer with the laser light for removal from the to-be-bonded substrate based on the map data for removal, causing a portion of the adhesive which is included in the failure portion to absorb the laser light for removal and causing the portion of the adhesive which is included in the failure portion to sublimate, thereby removing the portion of the light-emitting device structure which is included in the failure portion to obtain the bonded light-emitting device wafer.

With such an inventive method for producing a bonded light-emitting device wafer, it is possible that the map data for removal is produced by optically investigating the failure portion of the bonded wafer, and the failure portion in the light-emitting device structure included in the bonded light-emitting device wafer (for example, bonding-failure portion and device characteristics failure portion) can be selectively removed by irradiating with the laser light based on the produced map data for removal. Moreover, according to the inventive method for producing a bonded light-emitting device wafer, the failure portion of the light-emitting device structure can be selectively removed with ease without using a mechanical method. That is, according to the inventive method for producing a bonded light-emitting device wafer, the bonded light-emitting device wafer, in which the failure portion of the light-emitting device structure has been removed, can be easily produced.

It is preferable that
in the step of producing the map data for removal,
the following steps are performed:
   obtaining a photoluminescence spectrum of the bonded wafer and producing a first map data for the failure portion by using a peak wavelength, a peak intensity, and/or a half width of peak as criteria; and
   photographing the bonded wafer from the to-be-bonded substrate with a CCD camera and producing a second map data for the failure portion based on a color tone of an image obtained by the photographing,
wherein, the map data for removal is produced by using the first map data and the second map data.

By basing on the map data for removal produced in this way, all of the bonding-failure portion and the device characteristics failure portion of the light-emitting device structure included in the bonded light-emitting device wafer can be selectively and reliably removed.

In this case, for example, the light-emitting device structure can be subjected to device isolation processing, and
the map data for removal can be produced for the bonded wafer including the light-emitting device structure subjected to the device isolation processing.

The first map data and the second map data may be produced for the bonded wafer, including the light-emitting device structure having been isolated into the device, and these map data may be merged to produce the map data for removal. In this way, the failure portion of the light-emitting device structure can be selectively removed with ease without affecting a good portion of the light-emitting device structure.

Alternatively, it is also possible that
in the step of producing the map data for removal,
a step of irradiating a surface of the light-emitting device structure of the bonded wafer with a laser light for topology detection from an oblique direction to obtain topology data and producing a topology map data for the failure portion based on the topology data is further performed,
wherein the map data for removal for the failure portion is produced by using the first map data, the second map data, and the topology map data, and
the light-emitting device structure is subjected to device isolation processing after removing the portion of the light-emitting device structure which is included in the failure portion.

When producing the map data for removal before the device isolation processing, the above topology map data can be obtained and merged with the above first map data and the above second map data to produce the map data for removal; and by performing the removal with the laser based on this map data for removal, all of the bonding-failure portion and the device characteristics failure portion of the light-emitting device structure included in the bonded light-emitting device wafer can be selectively and reliably removed. Furthermore, as a result, an accuracy-failing portion in photolithography around the failure portion of the light-emitting device structure can be reduced.

For example, as the laser light for removal, a laser light having a wavelength of 170 nm or more and 360 nm or less can be used.

The laser light for removal is not particularly limited as long as the laser light can pass through the to-be-bonded substrate and can be absorbed by the adhesive, but the laser light having a wavelength of 170 nm or more and 360 nm less can be used.

For example, as the adhesive, an adhesive having an optical absorption edge in a wavelength region of 170 nm or more and 360 nm or less can be used.

Such an adhesive can be easily vaporized by using the laser light for removal, which has a wavelength of 170 nm or more and 360 nm or less.

In this case, for example, the adhesive can be selected from the group consisting of benzocyclobutene, silicone resin, epoxy resin, SOG, polyimide, and amorphous fluororesin.

The adhesive is not particularly limited as long as the laser light for removal is absorbed into the adhesive, but the light-emitting device structure can be firmly bonded to the to-be-bonded substrate by using, for example, such adhesives.

It is preferable that before removing the portion of the light-emitting device structure, which is included in the failure portion, a protective material is coated on the light-emitting device structure.

Such a protective material can prevent the good portion of the light-emitting device structure, which is not to be removed, from being damaged by a receiving jig and the like when the bonded wafer is irradiated with the laser light.

It is preferable that as the protective material, a protective material containing polyvinyl acetate or a protective material containing polyvinyl alcohol is used.

Such a protective material is preferable because of easy removability thereof.

Moreover, the present invention provides a method for transferring a micro LED in which the micro LED is transferred from a bonded light-emitting device wafer including the micro LED to a transfer destination substrate, the method comprising:
producing a bonded light-emitting device wafer including a light-emitting device structure subjected to the device isolation processing by the inventive method for producing a bonded light-emitting device wafer; and
transferring the light-emitting device structure as the micro LED from the bonded light-emitting device wafer to the transfer destination substrate.

As described above, in the inventive method for producing a bonded light-emitting device wafer, the failure portion in the light-emitting device structure included in the bonded light-emitting device wafer (for example, bonding-failure portion and device characteristics failure portion) can be selectively removed; as a result, the bonded light-emitting device wafer, in which the failure portion of the light-emitting device structure has been removed, can be produced. Consequently, according to the inventive method for transferring a micro LED, the transfer of a faulty light-emitting device structure, i.e., a faulty micro LED, can be prevented.

### ADVANTAGEOUS EFFECTS OF INVENTION

As described above, according to the inventive method for producing a bonded light-emitting device wafer, the failure portion in the light-emitting device structure included in the bonded light-emitting device wafer can be selectively removed. That is, according to the inventive method for producing a bonded light-emitting device wafer, the bonded light-emitting device wafer that does not include the faulty light-emitting device structure can be produced.

Moreover, according to the inventive method for transferring a micro LED, the transfer of the faulty micro LED can be prevented.

### BRIEF DESCRIPTION OF DRAWINGS

FIG. 1 is a schematic flowchart of a method for producing a bonded light-emitting device wafer according to the present invention.
FIG. 2 is a schematic cross-sectional view illustrating a part of a step of obtaining a bonded wafer in the first embodiment of a method for producing a bonded light-emitting device wafer according to the present invention.
FIG. 3 is a schematic cross-sectional view illustrating another part of a step of obtaining a bonded wafer in the first embodiment of a method for producing a bonded light-emitting device wafer according to the present invention.
FIG. 4 is a schematic cross-sectional view of a bonded wafer obtained in a step of obtaining the bonded wafer in the first embodiment of a method for producing a bonded light-emitting device wafer according to the present invention.
FIG. 5 is a schematic plane view of a bonded wafer obtained in a step of obtaining the bonded wafer in the first embodiment of a method for producing a bonded light-emitting device wafer according to the present invention.
FIG. 6 is a schematic cross-sectional view illustrating a part of a step of obtaining a bonded light-emitting device wafer in the first embodiment of a method for producing a bonded light-emitting device wafer according to the present invention.
FIG. 7 is a schematic plane view of a bonded-wafer-receiving jig used in the first embodiment of a method for producing a bonded light-emitting device wafer according to the present invention.
FIG. 8 is a schematic cross-sectional view illustrating another part of a step of obtaining a bonded light-emitting device wafer in the first embodiment of a method for producing a bonded light-emitting device wafer according to the present invention.
FIG. 9 is a part of a map data for removal used in the first embodiment of a method for producing a bonded light-emitting device wafer according to the present invention.
FIG. 10 is a schematic plane view illustrating irradiation of laser light for removal in the first embodiment of a method for producing a bonded light-emitting device wafer according to the present invention.
FIG. 11 is a schematic cross-sectional view illustrating irradiation of laser light for removal in the first embodiment of a method for producing a bonded light-emitting device wafer according to the present invention.
FIG. 12 is a schematic plane view of a light-emitting device structure after removing a portion of the light-emitting device structure which is included in a failure portion in the first embodiment of a method for producing a bonded light-emitting device wafer according to the present invention.
FIG. 13 is a schematic cross-sectional view of a bonded light-emitting device wafer obtained after removing a portion of the light-emitting device structure which is included in a failure portion in the first embodiment of a method for producing a bonded light-emitting device wafer according to the present invention.
FIG. 14 is a schematic cross-sectional view of a bonded light-emitting device wafer after device isolation processing in the first embodiment of a method for producing a bonded light-emitting device wafer according to the present invention.
FIG. 15 is a schematic cross-sectional view illustrating a part of a step of forming a protective film in the first embodiment of a method for producing a bonded light-emitting device wafer according to the present invention.
FIG. 16 is a schematic cross-sectional view of a bonded light-emitting device wafer obtained in the first embodiment of a method for producing a bonded light-emitting device wafer according to the present invention.

### DESCRIPTION OF EMBODIMENTS

As described above, the development of a method for producing a bonded light-emitting device wafer has been desired, in which the method can selectively remove a failure portion of a light-emitting device structure, which is to be a micro LED being bonded to a to-be-bonded wafer via an adhesive, to produce the bonded light-emitting device wafer. In addition, the development of a method for transferring a micro LED, which can prevent transfer of a faulty micro LED, has been desired.

To solve the above problem, the present inventor has earnestly studied and found out that the failure portion of the light-emitting device structure included in the bonded light-emitting device wafer can be selectively removed by optically investigating the failure portion of the bonded wafer to produce a map data for removal and by irradiating with a laser light based on the produced map data for removal. This finding has led to the completion of the present invention.

That is, the present invention is a method for producing a bonded light-emitting device wafer, in which a light-emitting device structure, to be a micro LED, and a to-be-bonded substrate transparent to a laser light for removal are bonded with each other via an adhesive that absorbs the laser light for removal, the method comprising the steps of:
bonding the light-emitting device structure to the to-be-bonded substrate via the adhesive to obtain a bonded wafer;
producing a map data for removal by optically investigating a failure portion of the bonded wafer; and
irradiating the failure portion of the bonded wafer with the laser light for removal from the to-be-bonded substrate based on the map data for removal, causing a portion of the adhesive which is included in the failure portion to absorb the laser light for removal and causing the portion of the adhesive which is included in the failure portion to sublimate, thereby removing the portion of the light-emitting device structure which is included in the failure portion to obtain the bonded light-emitting device wafer.

In addition, the present invention is a method for transferring a micro LED in which the micro LED is transferred from a bonded light-emitting device wafer including the micro LED to a transfer destination substrate, the method comprising:
producing a bonded light-emitting device wafer including a light-emitting device structure subjected to the device isolation processing by the method for producing a bonded light-emitting device wafer according to the present invention; and
transferring the light-emitting device structure as the micro LED from the bonded light-emitting device wafer to the transfer destination substrate.

Hereinafter, the present invention will be described in detail with reference to the drawings. However, the present invention is not limited thereto.

### [Method for Producing Bonded Light-Emitting Device Wafer]

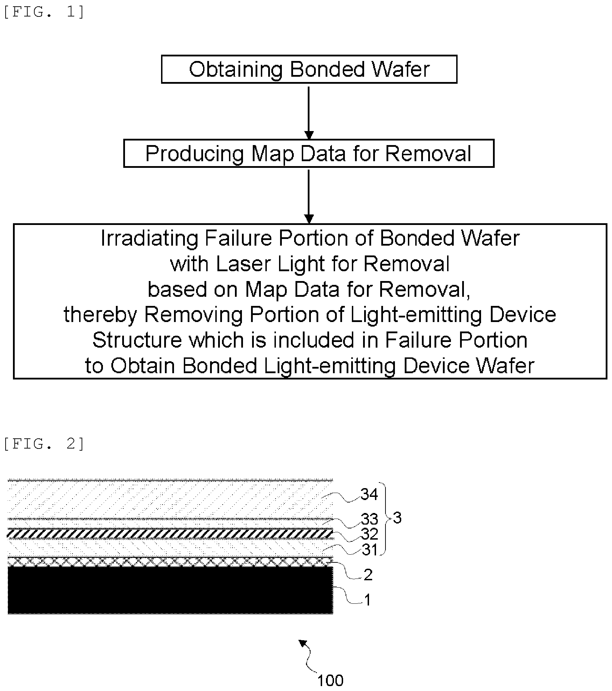

FIG. 1 shows a schematic flowchart of the inventive method for producing a bonded light-emitting device wafer. In general, the inventive method for producing a bonded light-emitting device wafer includes the steps of obtaining the bonded wafer; producing the map data for removal; and irradiating the failure portion of the bonded wafer with the laser light for removal based on the map data for removal, thereby removing the portion of the light-emitting device structure, which is included in the failure portion, to obtain the bonded light-emitting device wafer.

Hereinafter, such a method for producing a bonded light-emitting device wafer will be described with reference to greater detailed specific examples.

### (First Embodiment)

### <Step of Obtaining Bonded Wafer>

First, the step of obtaining the bonded wafer in this embodiment is described with reference to FIGS. 2 to 5.

First, on a first conductivity-type GaAs starting substrate 1 shown in FIG. 2, a first conductivity-type GaAs buffer layer (not shown) is stacked, then a first conductivity-type GaₓIn₁₋ₓP (0.4 ≤ x ≤ 0.6) first etching stop layer having a thickness of 0.1 µm, and a first conductivity-type GaAs second etching stop layer having a thickness of 0.1 µm are sequentially grown to form an etching stop layer 2. Subsequently, as shown in FIG. 2, on the etching stop layer 2, a first conductivity-type (Al_{y}Ga_{1-y})ₓIn₁₋ₓP (0.4 ≤ x ≤ 0.6, 0.6 ≤ y ≤ 1.0) first cladding layer 31 having a thickness of 1.0 µm, a non-doped (Al_{y}Ga_{1-y})ₓIn₁₋ₓP (0.4 ≤ x ≤ 0.6, 0 ≤ y ≤0.5) active layer 32 having a thickness of 0.6 µm, a second conductivity-type (Al_{y}Ga_{1-y})ₓIn₁₋ₓP (0.4 ≤ x ≤ 0.6, 0.6 ≤ y ≤ 1.0) second cladding layer 33 having a thickness of 1.0 µm, a second conductivity-type GaₓIn₁₋ₓP (0.5 ≤ x ≤ 1.0) intermediate layer (not shown) having a thickness of 0.1 µm, and a second conductivity-type GaP window layer 34 are sequentially grown to provide an EPW (epitaxial wafer) 100 having a light-emitting device structure 3 as an epitaxial functional layer. Here, the first cladding layer 31 to the second cladding layer 33 are referred to as a DH structure portion. Moreover, the light-emitting device structure 3 is to be processed to the device (dice), being a to-be-micro LED, by processing in a later stage.

The film thicknesses exemplified above are just examples, and the film thickness is no more than a parameter to be changed according to the operating specifications of the device; therefore, it is needless to say that the film thickness is not limited to the thicknesses described here. Moreover, it is needless to say that there is a concept in which each layer is not a single composition layer, but has a layer of a plurality of compositions within a range of compositions shown in the example. Furthermore, it is needless to say that there is a concept in which a level of a carrier concentration is not uniform in each layer but the concentration has a plurality of levels in each layer.

The active layer 32 may be composed of a single composition or may have the structure where a plurality of barrier layers and active layers are alternatively stacked, it is needless to say that the same function can be exhibited in each case and it is needless to say that any one of the both cases can be selected.

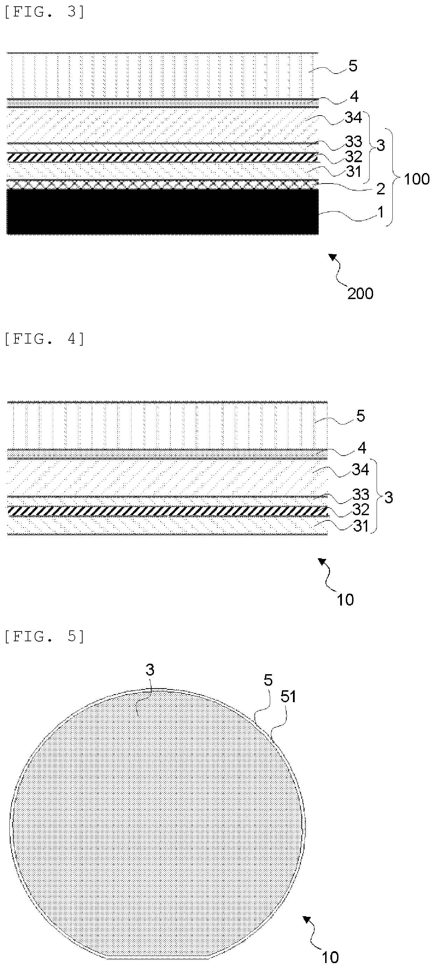

Subsequently, as an adhesive (thermosetting bonding material), benzocyclobutene (BCB) 4 is spin-coated on the EPW 100, and then the light-emitting device structure 3 and a sapphire wafer, being the to-be-bonded substrate 5, are superimposed facing each other via the adhesive 4 and then thermocompression-bonding is performed. Thereby, an EPW bonded substrate 200 is produced, in which the light-emitting device structure 3 of the EPW 100 and the sapphire wafer 5 are bonded to each other via the BCB 4, as shown in FIG. 3. In this embodiment, when the BCB is coated by spin-coating, a designed film thickness of a layer of the BCB 4 is set to 0.6 µm.

Although the to-be-bonded substrate 5 is exemplified as sapphire in this embodiment, it is needless to say that the to-be-bonded substrate 5 is not limited to sapphire, and any material can be selected as long as transparency to laser light for removal described later and flatness are guaranteed. Quartz can be selected instead of sapphire.

In this embodiment, a case where the BCB 4 is in a state of being coated in a layered shape is exemplified, but it is needless to say that the adhesive 4 is not limited to the layered shape. It is needless to say that the same result can be obtained by patterning photosensitive BCB to an isolated island shape, a line shape, or other shapes, and then by performing a bonding step.

Next, the GaAs starting substrate 1 is removed by wet etching to expose the first etching stop layer; the etchant is then switched, and the second etching stop layer is removed. The etching stop layer 2 is removed and the first cladding layer 31 is exposed in this manner to produce a bonded wafer (EP bonded substrate) 10 is produced, in which the light-emitting device structure 3, including the DH layer and the window layer 34, and the to-be-bonded substrate 5 are bonded each other via the adhesive 4, as shown in FIG. 4.

Although the BCB thickness of 0.6 µm is exemplified in this embodiment, it is needless to say that the thickness of the adhesive 4 is not limited to this thickness and the same effect can be obtained even when the thickness thereof is thicker or thinner than this thickness.

FIG. 5 shows a schematic plane view of an example bonded wafer obtained in a step of obtaining the bonded wafer in this embodiment. The light-emitting device structure 3 bonded to to-be-bonded wafer 5 via an adhesive, not shown in the drawing, is included in the bonded wafer 10 shown in FIG. 5. An unbonded-to-the-light-emitting-device-structure region 51, which is not bonded to the light-emitting device structure 3, is included in a peripheral portion of the to-be-bonded wafer 5.

### <Step of Producing Map Data for Removal>

Next, the step of producing a map data for removal is performed by optically investigating the failure portion of the bonded wafer 10.

In this embodiment, a first map data for the failure portion, a topology map data for the failure portion, and a second map data for the failure portion are produced, and then the map data for removal for the failure portion is produced by using these map data.

Hereinafter, obtainment of respective map data is described.

### [First Map Data]

First, an entire region of the bonded wafer 10 is irradiated with a laser having a wavelength of 325 to 532 nm and a spot diameter of 100 µm at a pitch of 25 µm, photoluminescence (PL) spectrum is collected, and the first map data is produced. Any of the wavelengths described above can be selected for the wavelength of the laser, but a solid-state laser having an emission wavelength of 532 nm is used in this embodiment.

In this embodiment, a designed wavelength of EPW 100 is designed to 632 nm, a position within a range of 632 ± 5 nm is determined as a passing grade, and a position within another wavelength region is determined as a failing grade, and then the first map data for the failure portion, especially for the device-characteristics-failure portion is produced.

Although the wavelength is exemplified as an investigation item for the failure portion in this embodiment, it is needless to say that criteria are not limited to the wavelength. Stress is often applied to a protrusion-shaped failure portion due to deformation, and a crack may be generated. Because the half-width of peak is increased due to high stress and PL intensity is significantly decreased due to a generation of the crack, the first map data may be produced using the PL intensity or the half- width as the criteria, or as additional criteria.

### [Topology Map Data]

A surface of the light-emitting device structure 3 of the bonded wafer 10 shown in FIG. 4 is irradiated with a laser having an emission wavelength of 532 nm from an oblique direction. In a system having a photodetector arranged at a position in reflection direction at the same angle as laser incident angle, an entire surface of the wafer is irradiated with a laser at a pitch of 25 µm, and deviation of reflection angle is measured. The reflection angle is deviated upward at a protrusion portion of the light-emitting device structure 3, and the reflection angle is deviated downward at an indentation portion; therefore, the topological data are collected from the deviations of the reflection angles. The topology map data are produced using height tolerance as a threshold where a point within the tolerance is determined as a passing grade, and a point other than that is determined as a failing grade.

### [Second Map Data]

The bonded wafer 10 in FIG. 4 is photographed from the to-be-bonded substrate (sapphire substrate) 5 with a CCD camera, and a passing grade and a failing grade are determined based on a color tone. The failing grade marked as the bonding-failure tends to be the color tone slightly whiter (lighter) than the point with uniform bonding, and pass or fail is decided based on a difference in contrast; the second map data is then produced regarding the failure portion, especially the bonding-failure portion, in which the pass or fail is determined at 25 µm pitch mesh.

The failure portions on the first map data, the topology map data, and the second map data obtained as described above are superimposed to produce the map data for removal. Although the respective positions of the three types of map meshes do not match each other, any region defined as a failure portion in any one type of the map is defined as a failure portion, and then the map data for removal is produced.

### <Step of Irradiating Failure Portion of Bonded Wafer with Laser Light for Removal based on Map Data for Removal, thereby Removing Portion of Light-Emitting Device Structure which is included in Failure Portion to obtain Bonded Light-Emitting Device Wafer>

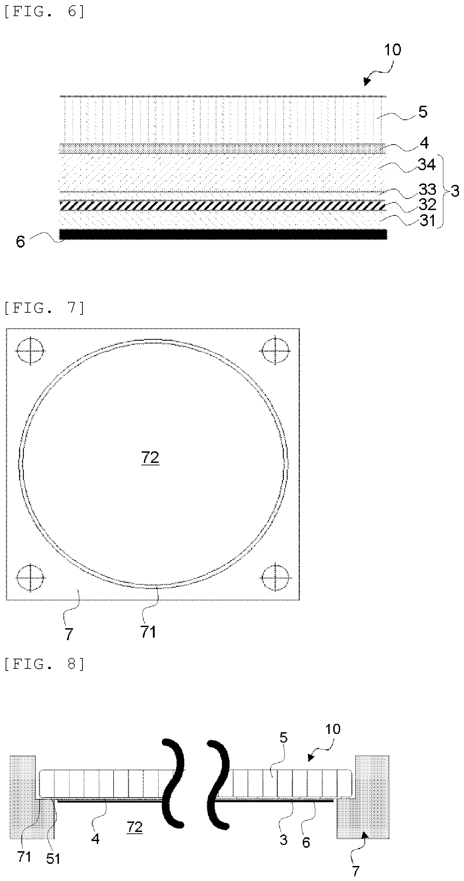

In this step, the bonded light-emitting device wafer is obtained by a procedure described below, referring to FIGS. 6 to 16.

First, as shown in FIG. 6, a protective material 6 is coated on a surface of the bonded wafer 10 from which the starting substrate was removed. In this embodiment, HogoMax (registered trademark: propylene glycol monomethyl ether and polyvinyl alcohol are contained according to SDS) manufactured by DISCO Corporation is coated by spin-coating as the protective material 6, but a material of the protective material 6 is not limited to HogoMax, and any material that has a function of the protective material and is easily removable can be selected. Other than HogoMax, for example, polyvinyl acetate and polyvinyl alcohol are also suitable.

Subsequently, the bonded wafer 10 coated with the protective material 6 is introduced into a laser processing unit. When introducing the wafer, for example, the bonded wafer 10 is held by a bonded-wafer-receiving jig 7, as shown in FIG. 7, and introduced in the laser processing unit. The bonded-wafer-receiving jig 7 shown in FIG. 7 is provided with an opening region 72 in the center, and a periphery of the opening region 72 serves as a wafer-receiving-groove portion 71. When holding the wafer, the light-emitting device structure 3 is made to be located at the opening region 72, as shown in FIG. 8.

Moreover, when introducing the bonded wafer 10, the introduction is performed with a coated surface of the protective material 6 facing downward, as shown in FIG. 8. Although a case where the coated surface of the protective material 6 facing downward is exemplified in this embodiment, the case is not limited to the state of facing downward; it is needless to say that the coated surface may be set facing upward or side. However, the case where the coated surface of the protective material 6 is faced downward is suitable because the failure portion to be removed by sublimation of the BCB 4 layer, as described later, more easily falls below the wafer along gravity so that an amount of debris adhering to the coated surface of the protective material 6 can be reduced. It should be noted that it is needless to say that the introduction method is not limited to the method facing downward because the protective material 6 is removed in the end, and the debris is removed along with it.

As shown in FIG. 5, the light-emitting device structure 3 is not bonded around a periphery of the bonded wafer 10 in a width of about 1 to 2 mm, and a region 51 to which the light-emitting device structure is not bonded is present where the to-be-bonded substrate (sapphire substrate) 5 or the adhesive 4 is exposed. When holding the bonded wafer 10 with a coated portion of the protective material 6 facing downward, a wafer-receiving-groove portion 71 of the jig 7 is designed to overlap with this region 51 to which the light-emitting device structure is not bonded, as shown in FIG. 8, to hold the wafer.

Next, the region defined as the failure portion is irradiated with the laser for removal from the to-be-bonded substrate (sapphire substrate) 5 of the bonded wafer 10 based on the map data for removal obtained earlier.

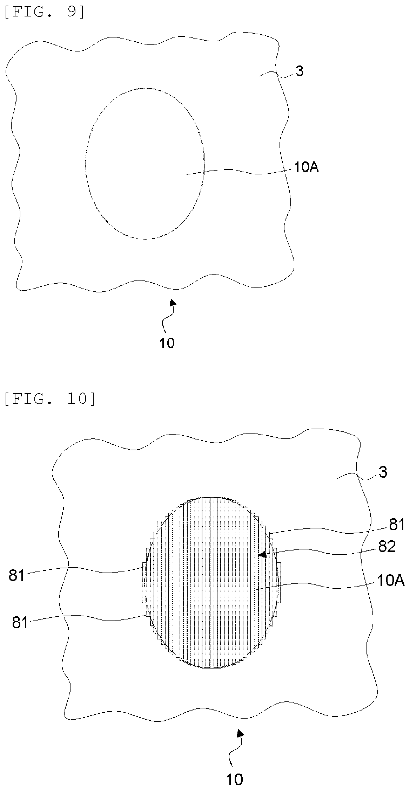

FIG. 9 shows a part of an example of the map data for removal. The map data for removal shown in FIG. 9 shows a failure portion 10A of the bonded wafer 10 at the center. The failure portion 10A includes the failure portion of the light-emitting device structure 3.

This failure portion 10A is irradiated with the laser light for removal a plurality of times using a laser lift-off method (LLO), as shown in FIG. 10, in this embodiment. As a result, a plurality of laser irradiation areas (per occurrence) 81 are generated, and as a whole, a laser irradiation region 82 that can be referred to as almost exclusively failure portion 10A is generated. In another aspect, all of the failure portion 10A (failure portion of light-emitting device structure 3 is included) of the bonded wafer 10 can be irradiated with the laser light for removal.

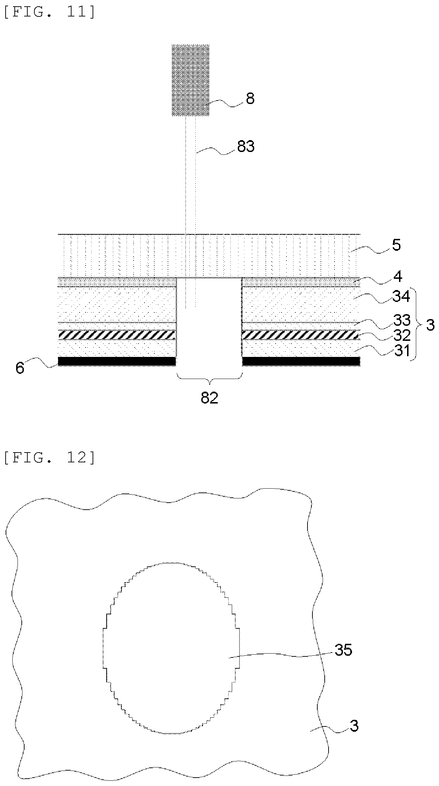

FIG. 11 shows a state where the protrusion-shaped failure portion of the light-emitting device structure 3 have been fallen off by virtue of the incident of the laser light 83 for removal from the to-be-bonded substrate 5 and the absorption of the laser light 83 for removal into a portion of the BCB (adhesive) 4, which is included in the failure portion 10A of the bonded wafer 10 so that a portion of the BCB 4 which is included in the failure portion 10A is sublimated to be a gaseous body, and then the light-emitting device structure 3 is split and the adhesive strength of the failure portion of light-emitting device structure 3 to the to-be-bonded substrate 5 by the BCB 4 is reduced. The failure portion is cleanly split almost along a cleavage line direction and falls; therefore, an effect on an adjacent good portion in the light-emitting device structure 3 can be minimized.

That is, a portion (failure portion) of the light-emitting device structure 3, which is included in the failure portion 10A of the bonded wafer 10, can be removed by irradiating such a failure portion 10A of the bonded wafer 10 with the laser light for removal.

Although a KrF excimer laser having a wavelength of 248 nm is used as the laser light 83 for removal, the wavelength is not limited to this, and any laser light can be selected as long as the laser light is transparent to the to-be-bonded substrate (sapphire substrate) 5 and is absorbed by the adhesive (for example, BCB) 4. For example, laser light (ultraviolet light) having a wavelength of 170 nm or more and 360 nm or less can be used as the laser light 83 for removal.

FIG. 10, as described earlier, is a conceptual diagram showing when the bonding-failure portion is removed by the LLO (laser lift-off) described above. In LLO, the removal area (portion of light-emitting device structure 3, which is included in failure portion 10A of bonded wafer 10) is irradiated with laser light along a profile, as shown in FIG. 10. After the laser irradiation, a region 35 having a minimum area from which the failure potion has been removed, can be obtained as shown in FIG. 12. In other words, all failure portions can be removed with a small excess which can be referred to as almost the failure portion.

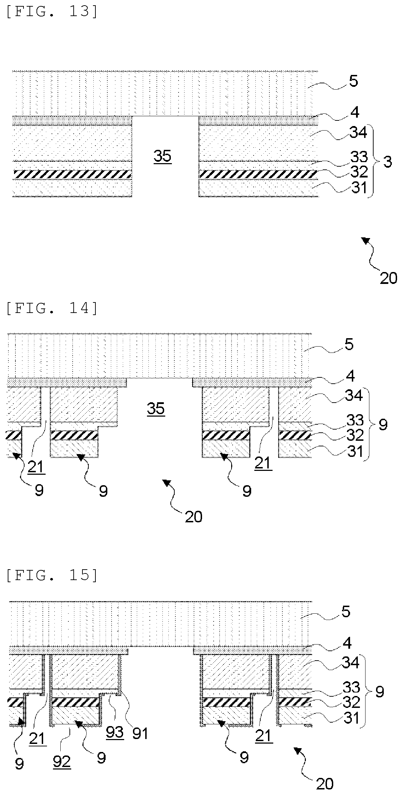

Subsequently, the bonded wafer 10 is taken out from the laser processing unit and is cleaned with pure water while facing the coated surface of the protective material 6 upward to remove the protective material 6. As a result, a bonded light-emitting device wafer 20 can be obtained, in which light-emitting device structure 3, including the region 35 where the failure potion has been removed, and the to-be-bonded substrate 5 are bonded via the adhesive 4, as shown in FIG. 13. The wafer 20 before removing the protective material 6 can also be referred to as the bonded light-emitting device wafer.

The light-emitting device structure 3 is a structure to be a micro LED and can be subjected to, for example, device isolation processing, as shown below. An example of processing is described below.

A mask pattern is formed on the light-emitting device structure 3 by a photolithography method, and the light-emitting device structure 3 is subjected to device isolation processing by ICP. With this process, the light-emitting device structure 3 is formed into devices (light-emitting device structures subjected to device isolation processing, i.e., dice) 9 isolated by isolation grooves 21, as shown in FIG. 14. Gases used in the ICP are, for example, chlorine and argon. The ICP processing is performed twice: for example, a step of exposing a layer of BCB 4 and a step of exposing a part of a main surface of the second cladding layer 33.

Although a case where a part of the main surface of the second cladding layer 33 is exposed is exemplified in this embodiment, it is needless to say that the case is not limited to the case where a part of the main surface of the second cladding layer 33 is exposed, and it is needless to say that a purpose of processing can be achieved when an active layer 32 is, at least, isolated. It is needless to say that the same effect can be obtained even when a part of a main surface of the GaP window layer 34 is exposed instead of the exposure of the second cladding layer 33.

After device isolation processing, a protective film 91 is formed as end face processing, as shown in FIG. 15. In this embodiment, SiO₂ is used as the protective film 91. The protective film 91 is not limited to SiO₂, but any material can be selected as long as the end face can be protected and the material has insulating properties. SiNₓ, titanium oxide, magnesium oxide, etc., can also be selected. The protective film 91 is provided with an opening 92 that exposes a part of a main surface of the first cladding layer 31 and an opening 93 that exposes a part of the main surface of the second cladding layer 33.

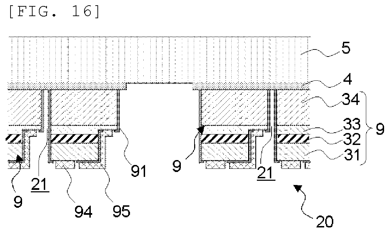

Following the formation of the protective film 91, as shown in FIG. 16, electrodes 94 and 95 are formed in contact with the first conductivity-type layer and the second conductive-type layer, respectively, and ohmic contact is then formed by performing heat treatment. In this embodiment, the first conductivity-type is designed as N-type, and the second conductivity-type is designed as P-type; metals containing Au and Si are used for the N-type electrode 94 in contact with the first cladding layer 31 which is the N-type layer through the opening 92, and metals containing Au and Be are used for the P-type electrode 95 in contact with the second cladding layer 33 which is the P-type layer through the opening 93.

In this embodiment, although the metals of Au and Si are used for the N-type electrode, it is needless to say that the material thereof is not limited to these, but the same result can be obtained by using the metals containing Au and Ge. Moreover, the metals of Au and Be are used for the P-type electrode, but it is needless to say that the material thereof is not limited to these, and the same result can be obtained even when the metals containing Au and Zn are used.

Moreover, the BCB is used as the adhesive 4 in this embodiment, the material of the adhesive 4 used in the present invention is not limited to the BCB as long as the material can absorb the laser light 83 for removal. For example, when using the to-be-bonded substrate 5 that is transparent to the laser light 83 for removal having a wavelength of 170 nm or more and 360 nm or less, if the adhesive 4 has an optical absorption edge in a wavelength region of 170 nm or more and 360 nm or less, the adhesive can be easily sublimated with the laser light 83 for removal having a wavelength of 170 nm or more and 360 nm or less that can transmit through the to-be-bonded substrate 5. Examples of the adhesive 4 can include silicone resin, epoxy resin, SOG, polyimide, and amorphous fluororesin (e.g., CYTOP (registered trademark)) in addition to BCB, and by using these, the light-emitting device structure 3 and the to-be-bonded substrate 5 can be firmly bonded.

### (Second Embodiment)

In the second embodiment, the step for obtaining a bonded wafer 10 is the same as in that of the first embodiment, but the second embodiment is different from the first embodiment in that device isolation processing and electrode formation processing to a light-emitting device structure 3 are performed before the step of obtaining a map data for removal.

The device isolation processing and the electrode formation processing can be performed in the same procedure as described with reference to FIGS. 14 to 16, except that a failure portion of the light-emitting device structure 3 is not taken out. In the second embodiment, the device isolation (dice) processing and the electrode attachment are performed while the failure portion is present in the light-emitting device structure 3, consequently, a device having fault shape and size may be formed in the failure portion. Such a failure portion is removed later by irradiating with a laser for removal based on the map data for removal.

However, unlike the first embodiment, the second embodiment is unsuitable for obtaining topology map data as dicing processing has been already performed, thus only first map data and second map data are obtained.

Subsequently, in the same way as in the first embodiment, the first map data and the second map data for the failure portion are used and overlapped each other to produce the map data for removal.

When removing the failure portion, a protective material is coated on a surface of a device obtained by device isolation on the light-emitting device structure of the bonded wafer as in the first embodiment. Subsequently, in the same procedure as in the first embodiment, the failure portion is irradiated with a laser from a sapphire substrate and removed. The protective material is then cleaned with water and removed in the same way as in the first embodiment. In this way, a bonded light-emitting device wafer can be obtained, in which the light-emitting device structure (device) from which the failure portion has been removed, and the to-be-bonded substrate are bonded each other via the adhesive.

According to the inventive method for producing a bonded light-emitting device wafer described above, the failure portion of the light-emitting device structure can be selectively removed with ease without using a mechanical method and without affecting a good portion (e.g., another dice region) of the light-emitting device structure. Moreover, according to the present invention, all portions of the light-emitting device structure which is included in the failure portion of the bonded wafer can be removed.

In particular, as in the first embodiment, an accuracy-failing portion in photolithography around the failure portion can be reduced by removing a bonding-failure portion (in particular, protrusion-shaped failure portion) before initiating device processing such as device isolation processing.

Moreover, in the second embodiment, the failure portion of the light-emitting device structure can be selectively removed with ease without using a mechanical method and without affecting a good portion (e.g., another dice region) of the light-emitting device structure.

### <Method for Transferring micro LED>

The inventive method for transferring a micro LED is a method for transferring a micro LED in which the micro LED is transferred from a bonded light-emitting device wafer including the micro LED to a transfer destination substrate, the method includes producing a bonded light-emitting device wafer including a light-emitting device structure subjected to the device isolation processing by the method for producing a bonded light-emitting device wafer described above; and transferring the light-emitting device structure, as the micro LED, from the bonded light-emitting device wafer to the transfer destination substrate.

As described above, in the inventive method for producing a bonded light-emitting device wafer, the failure portion in the light-emitting device structure included in the bonded light-emitting device wafer (for example, bonding-failure portion and device-characteristics-failure portion) can be selectively removed; as a result, the bonded light-emitting device wafer including the light-emitting device structure from which the failure portion has been removed can be produced. Consequently, according to the inventive method for transferring a micro LED, the transfer of a faulty light-emitting device structure, i.e., a faulty micro LED, can be prevented.

### EXAMPLES

Hereinafter, the present invention will be specifically described with reference to Examples and Comparative Example. However, the present invention is not limited thereto.

### (First Example)

In First Example, a bonded light-emitting device wafer was produced in the same way as in the first embodiment described earlier. Specifically, the following is the case.

First, an EPW 100 having an EPW structure shown in FIG. 2 was obtained using the same procedure described earlier.

Next, BCB 4 was coated by spin-coating on a light-emitting device structure 3 of the EPW 100 by setting a designed film thickness of 0.6 µm.

This wafer was superimposed with a sapphire wafer, being a to-be-bonded wafer 5, facing each other, and thermocompression-bonded thereto to produce an EPW bonded substrate 200.

Next, a GaAs starting substrate 1 was removed by wet etching to expose a first etching stop layer, an etchant was then switched to remove a second etching stop layer. As a result, a bonded wafer (EP bonded substrate) 10 (FIGS. 4 and 5) was produced, in which an etching stop layer 2 had been removed to expose a first cladding layer 31, and a light-emitting device structure 3, including a DH layer and a window layer 34, had been bonded to a to-be-bonded substrate 5 via an adhesive 4.

Next, a map data for removal was produced by the following procedure.

An entire region of the bonded wafer 10 was irradiated with a laser having a wavelength of 532 nm and a spot diameter of 100 µm at a pitch of 25 µm, and PL spectrum was collected and a map data was produced. In this Example, a designed wavelength of EPW was designed to 632 nm, and a position within a range of 632 ± 5 nm was determined as a passing grade, and a position within another wavelength region was determined as a failing grade, and then the first map data was produced.

Moreover, a surface of the light-emitting device structure 3 of the bonded wafer 10 was irradiated with a laser having an emission wavelength of 532 nm from an oblique direction. In a system having a photodetector arranged at a position in reflection direction at the same angle as laser incident angle, an entire surface of the wafer was irradiated with the laser at a pitch of 25 µm, and topological data were collected. By using height tolerance as a threshold, the topology map data were produced where a point within the tolerance was determined as a passing grade, and a point other than that was determined as a failing grade.

Moreover, the bonded wafer 10 was photographed from a sapphire substrate 5 with a CCD camera and a second map data, in which pass or fail was judged based on contrast difference at 25 µm pitch mesh, was produced.

The failure portions of the first map data, the topology map data, and the second map data obtained as above were superimposed to produce the map data for removal.

Next, a surface of the light-emitting device structure 3 of the bonded wafer 10, from which the starting substrate had been removed, was coated with a protective material 6 by spin-coating of HogoMax (registered trademark) manufactured by DISCO Corporation as shown in FIG. 6.

The bonded wafer 10 coated with the protective material 6 was held as shown in FIG. 8 using a bonded-wafer-receiving jig 7 shown in FIG. 7 and introduced in a laser processing unit while facing the coated surface of the protective material 6 downward. In this case, as shown in FIG. 8, the wafer was held such that a wafer-receiving-groove portion 71 of the jig 7 was superimposed with an unbonded-to-the-light-emitting-device-structure region 51, where the sapphire substrate 5 was exposed.

In the laser processing unit, as shown in FIGS. 10 and 11, the only region defined as a failure portion 10A based on the map data for removal (and a small excess that can be referred to be the almost failure portion) was irradiated from the sapphire substrate 5 with KrF excimer laser having a wavelength of 248 nm to remove the failure portion.

Subsequently, the wafer was taken out from the laser processing unit and cleaned with pure water while facing the coated surface of the protective material 6 upward to remove the protective material 6 as shown in FIG. 13.

A mask pattern was then formed on the light-emitting device structure 30 by a photolithography method and device isolation processing was performed by ICP using chlorine and argon gases. The ICP processing was performed twice: a step of exposing the BCB layer 4 and a step of exposing a part of a main surface of the second cladding layer 33. By virtue of this device isolation processing, as shown in FIG. 14, the light-emitting device structure 30 was processed to be devices (light-emitting device structures having been subjected to device isolation processing) 9 being isolated by isolation grooves 21.

After device isolation processing, as shown in FIG. 15, an SiO₂ protective film 91 was formed as end face processing, and the protective film 91 was provided with an opening 92 that exposed a part of a main surface of the first cladding layer 31 and an opening 93 that exposed a part of the main surface of the second cladding layer 33.

Following the formation of the protective film 91, as shown in FIG. 16, electrodes 94 and 95 were formed in contact with the first conductivity-type layer and the second conductive-type layer, respectively, and ohmic contact was then formed by performing heat treatment. In this Example, the first conductivity-type was designed as N-type, and the second conductivity-type was designed as P-type; metals containing Au and Si were used for the N-type electrode 94 in contact with the first cladding layer 31 which is the N-type layer, and metals containing Au and Be were used for the P-type electrode 95 in contact with the second cladding layer 33 which is the P-type layer.

Thus, a bonded light-emitting device wafer 20 of First Example having a structure shown in FIG. 16 was obtained.

### (Second Example)

In Second Example, a bonded light-emitting device wafer was produced in the same procedure as in the second embodiment described earlier.

That is, in Second Example, the bonded light-emitting device wafer of Second Example was produced in the same way as in that of First Example, except that device isolation processing and electrode formation processing to a light-emitting device structure 3 were performed before a step of obtaining a map data for removal, and a topology map data was not obtained.

### (Comparative Example)

In Comparative Example, a bonded light-emitting device wafer of Comparative Example was produced in the same way as in First Example, except that a failure portion of a light-emitting device structure was not removed.

That is, in Comparative Example, the step of obtaining a bonded wafer 10 was performed in the same way as in that of First Example, moreover, device isolation processing and electrode formation processing were performed in the same way as in Second Example. However, in Comparative Example, unlike Second Example, production of a map data and removal of the failure portion were not performed, resulting in maintaining the failure portion of the light-emitting device structure intact.

### (Evaluation)

A table comparing a removal rate of a protrusion-shaped failure portion and a yield of a number of dice that did not cause problems during mounting in the end is shown below as Table 1.

**[Table 1]**

| | First Example | Second Example | Comparative Example |
|---|---|---|---|
| Removal Rate of Failure Portion | 101.2% | 100.0% | 0.00% |
| Yield of Mounted Dice | 92.8% (76.2 to 97.5%) | 94.9% (77.4 to 96.6%) | 77.6% (74.2 to 78.7%) |

In First Example, when the protrusion-shaped failure portion was removed, the failure portion and the good portion were connected to each other due to a state of wafer, and thus when BCB of the failure portion was sublimated and the light-emitting device structure was split, an adjacent good portion was sometimes cracked, causing the removal rate to exceed 100% slightly. In the case of Second Example, the failure portion was removed in a dice state, thus even when the BCB was sublimated and the light-emitting device structure was split, an impact on the adjacent good portion did not propagate because of the existence of the isolation groove between the dice, and the removal rate was 100% because of a recognized failure region and the region to be removed being approximately matched with each other. In the case of Comparative Example, the removal rate was 0% because no removal was performed.

Table 1 above shows the yield of the mounted dice when ten bonded light-emitting device wafers, obtained by each of the methods of the First and Second Examples and Comparative Example, were introduced in the step of mounting (transferring).

Figures in parentheses are variations of 10 wafers and figures outside parentheses are average values. When the dice were introduced in the transferring step after removing the failure portion by a method of First Example or Second Example, the yield of the mounted dice (number of effective dice as devices / number of dice that can be obtained from one wafer) was over 90% on average. In contrast, in Comparative Example where the protrusion failure portion was not removed before the transfer, during the step of pressing the dice to a transfer destination substrate at transfer, a breakage such as a crack and a chip was generated not only on the failure dice but also on surrounding dice due to the stress concentration to the protrusion failure portion. Therefore, the yield was significantly lowered compared to Examples where almost entirely the protrusion failure portion was successfully removed.

As shown above, the eventual mounting yield was able to be improved in First Example and Second Example where the failure portion was removed by LLO before transferring the dice to the transfer destination substrate and then the wafer was introduced in mounting processing.

The present description includes the following embodiments.
[1]: A method for producing a bonded light-emitting device wafer, in which a light-emitting device structure, to be a micro LED, and a to-be-bonded substrate transparent to a laser light for removal are bonded with each other via an adhesive that absorbs the laser light for removal, the method comprising the steps of:
   bonding the light-emitting device structure to the to-be-bonded substrate via the adhesive to obtain a bonded wafer;
   producing a map data for removal by optically investigating a failure portion of the bonded wafer; and
   irradiating the failure portion of the bonded wafer with the laser light for removal from the to-be-bonded substrate based on the map data for removal, causing a portion of the adhesive which is included in the failure portion to absorb the laser light for removal and causing the portion of the adhesive which is included in the failure portion to sublimate, thereby removing the portion of the light-emitting device structure which is included in the failure portion to obtain the bonded light-emitting device wafer.
[2]: The method for producing a bonded light-emitting device wafer according to [1], wherein
   in the step of producing the map data for removal, the following steps are performed:
      obtaining a photoluminescence spectrum of the bonded wafer and producing a first map data for the failure portion by using a peak wavelength, a peak intensity, and/or a half width of peak as criteria; and
      photographing the bonded wafer from the to-be-bonded substrate with a CCD camera and producing a second map data for the failure portion based on a color tone of an image obtained by the photographing,
   wherein, the map data for removal is produced by using the first map data and the second map data.
[3]: The method for producing a bonded light-emitting device wafer according to [2],
   wherein the light-emitting device structure is subjected to device isolation processing, and
   the map data for removal is produced for the bonded wafer including the light-emitting device structure subjected to the device isolation processing.
[4]: The method for producing a bonded light-emitting device wafer according to [2], wherein
   in the step of producing the map data for removal,
   a step of irradiating a surface of the light-emitting device structure of the bonded wafer with a laser light for topology detection from an oblique direction to obtain topology data and producing a topology map data for the failure portion based on the topology data is further performed,
   wherein the map data for removal for the failure portion is produced by using the first map data, the second map data, and the topology map data, and
   the light-emitting device structure is subjected to device isolation processing after removing the portion of the light-emitting device structure which is included in the failure portion.
[5]: The method for producing a bonded light-emitting device wafer according to any one of [1] to [4],
   wherein, as the laser light for removal, a laser light having a wavelength of 170 nm or more and 360 nm or less is used.
[6]: The method for producing a bonded light-emitting device wafer according to any one of [1] to [5],
   wherein, as the adhesive, an adhesive having an optical absorption edge in a wavelength region of 170 nm or more and 360 nm or less is used.
[7]: The method for producing a bonded light-emitting device wafer according to any one of [1] to [6],
   wherein, the adhesive is selected from the group consisting of benzocyclobutene, silicone resin, epoxy resin, SOG, polyimide, and amorphous fluororesin.
[8]: The method for producing a bonded light-emitting device wafer according to any one of [1] to [7],
   wherein, before removing the portion of the light-emitting device structure which is included in the failure portion, a protective material is coated on the light-emitting device structure.
[9]: The method for producing a bonded light-emitting device wafer according to [8],
   wherein, as the protective material, a protective material containing polyvinyl acetate or a protective material containing polyvinyl alcohol is used.
[10]: A method for transferring a micro LED in which the micro LED is transferred from a bonded light-emitting device wafer including the micro LED to a transfer destination substrate, the method comprising:
   producing a bonded light-emitting device wafer including a light-emitting device structure subjected to the device isolation processing by the method for producing a bonded light-emitting device wafer according to [3] or [4]; and
   transferring the light-emitting device structure as the micro LED from the bonded light-emitting device wafer to the transfer destination substrate.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a bonded light-emitting device wafer, in which a light-emitting device structure, to be a micro LED, and a to-be-bonded substrate transparent to a laser light for removal are bonded with each other via an adhesive that absorbs the laser light for removal, the method comprising the steps of:
bonding the light-emitting device structure to the to-be-bonded substrate via the adhesive to obtain a bonded wafer;
producing a map data for removal by optically investigating a failure portion of the bonded wafer; and
irradiating the failure portion of the bonded wafer with the laser light for removal from the to-be-bonded substrate based on the map data for removal, causing a portion of the adhesive which is included in the failure portion to absorb the laser light for removal and causing the portion of the adhesive which is included in the failure portion to sublimate, thereby removing the portion of the light-emitting device structure which is included in the failure portion to obtain the bonded light-emitting device wafer.

2. The method for producing a bonded light-emitting device wafer according to claim 1, wherein
in the step of producing the map data for removal, the following steps are performed:
obtaining a photoluminescence spectrum of the bonded wafer and producing a first map data for the failure portion by using a peak wavelength, a peak intensity, and/or a half width of peak as criteria; and
photographing the bonded wafer from the to-be-bonded substrate with a CCD camera and producing a second map data for the failure portion based on a color tone of an image obtained by the photographing,
wherein, the map data for removal is produced by using the first map data and the second map data.

3. The method for producing a bonded light-emitting device wafer according to claim 2,
wherein the light-emitting device structure is subjected to device isolation processing, and
the map data for removal is produced for the bonded wafer including the light-emitting device structure subjected to the device isolation processing.

4. The method for producing a bonded light-emitting device wafer according to claim 2, wherein
in the step of producing the map data for removal,
a step of irradiating a surface of the light-emitting device structure of the bonded wafer with a laser light for topology detection from an oblique direction to obtain topology data and producing a topology map data for the failure portion based on the topology data is further performed,
wherein the map data for removal for the failure portion is produced by using the first map data, the second map data, and the topology map data, and
the light-emitting device structure is subjected to device isolation processing after removing the portion of the light-emitting device structure which is included in the failure portion.

5. The method for producing a bonded light-emitting device wafer according to claim 1,
wherein, as the laser light for removal, a laser light having a wavelength of 170 nm or more and 360 nm or less is used.

6. The method for producing a bonded light-emitting device wafer according to claim 5,
wherein, as the adhesive, an adhesive having an optical absorption edge in a wavelength region of 170 nm or more and 360 nm or less is used.

7. The method for producing a bonded light-emitting device wafer according to claim 6,
wherein, the adhesive is selected from the group consisting of benzocyclobutene, silicone resin, epoxy resin, SOG, polyimide, and amorphous fluororesin.

8. The method for producing a bonded light-emitting device wafer according to any one of claims 1 to 7,
wherein, before removing the portion of the light-emitting device structure which is included in the failure portion, a protective material is coated on the light-emitting device structure.

9. The method for producing a bonded light-emitting device wafer according to claim 8,
wherein, as the protective material, a protective material containing polyvinyl acetate or a protective material containing polyvinyl alcohol is used.

10. A method for transferring a micro LED in which the micro LED is transferred from a bonded light-emitting device wafer including the micro LED to a transfer destination substrate, the method comprising:
producing a bonded light-emitting device wafer including a light-emitting device structure subjected to the device isolation processing by the method for producing a bonded light-emitting device wafer according to claim 3 or 4; and
transferring the light-emitting device structure as the micro LED from the bonded light-emitting device wafer to the transfer destination substrate.
